Europäisches Patentamt

European Patent Office

Office européen des brevets

(19)

(11) Veröffentlichungsnummer: **0 100 464**
**B1**

(12) **EUROPÄISCHE PATENTSCHRIFT**

(45) Veröffentlichungstag der Patentschrift:
18.10.89

(21) Anmeldenummer: 83106744.2

(22) Anmeldetag: 08.07.83

(51) Int. Cl.⁴: **H 03 F 1/18,** H 03 F 3/195,
H 03 F 3/60

(54) Kettenverstärker.

(30) Priorität: 29.07.82 DE 3228396

(43) Veröffentlichungstag der Anmeldung:
15.02.84 Patentblatt 84/7

(45) Bekanntmachung des Hinweises auf die Patenterteilung:
18.10.89 Patentblatt 89/42

(84) Benannte Vertragsstaaten:
DE FR GB IT SE

(56) Entgegenhaltungen:
US-A- 3 593 174

ELECTRONICS LETTERS, THE INSTITUTION OF
ELECTRICAL ENGINEERS, Band 17, Nr. 13, 25. Juni
1981, Seite 433, Stevenage, Herts, GB; J. A. ARCHER et
al.: "GaAs fet distributed amplifier"
ELECTRONICS LETTERS, THE INSTITUTION OF
ELECTRICAL ENGINEERS, Band 17, Nr. 12, 11. Juni
1981, Seiten 413,414, Londen, GB; Y. AYASLI:
"Monolithic GaAs travelling-wave amplifier"

(73) Patentinhaber: Siemens Aktiengesellschaft,
Wittelsbacherplatz 2, D-8000 München 2 (DE)

(72) Erfinder: Huber, Jakob, Dipl.-Phys., Flurweg 35,
D-8201 Beyharting (DE)
Erfinder: Pettenpaul, Ewald, Dr. Ing., Dipl.-Phys.,
Fasanenstrasse, D-8025 Unterhaching (DE)
Erfinder: Petz, Felix Anton, Dipl.-Phys., 100 School
House Rd., Somerset New Jersey 08873 (US)

## Beschreibung

Die Erfindung betrifft einen Kettenverstärker nach dem Oberbegriff des Anspruchs 1.

Ein solcher Kettenverstärker ist aus der Druckschrift «ELECTRONICS LETTERS», Band 17, Nr. 13, Seite 433, bekannt.

Ein einstufiger Kettenverstärker ist auch aus «Internationale elektronische Rundschau», 21. Jahrgang, 1967, Heft Nr. 5, Seiten 109–115, bekannt. Die für den Kettenverstärker notwendigen Bauteile wie Kapazitäten und Induktivitäten sind dabei jedoch diskrete Bauteile, die mit den im Halbleiter-Chip befindlichen Transistoren zu einem Kettenverstärker zusammengeschaltet sind. Um zu Verstärkern mit extremer Bandbreite zu gelangen, reicht jedoch eine Anschaltung von Diskreten äußeren Bauteilen bei einer Verstärkerschaltung nicht aus. Sollen derartige Verstärkerschaltungen bei Ausgangsleistungen von 0,1 Watt bis 1 Watt in einem möglichst großen Frequenzbereich bis hin zu 18 GHz arbeiten, so müssen die Eigeninduktivitäten, die Eigenkapazitäten und die Eigenwiderstände der geschalteten Feldeffekttransistoren mitberücksichtigt werden.

Bei der Druckschrift «ELECTRONICS LETTERS», Band 17, Nr. 12, Seiten 413–414, werden die Feldeffekttransistoren ebenfalls als individuelle Feldeffekttransistoren angesehen. Die Gate- und Drain-Leitungen sind dabei mit den Impedanzen der individuellen Feldeffekttransistoren belastet.

Bei der eingangs genannten Druckschrift sind die Feldeffekttransistoren als individuelle Bauelemente in der Kettenverstärker-Schaltung angeordnet. Parasitäre Kapazitäten und parasitäre Induktivitäten sind dabei störend, weil sie nicht vorteilhaft ausgenutzt werden. Dabei sind Eingangs- und Ausgangsleitungen in Mikrostreifen-Form ausgebildet. Die Leitungsimpedanzen werden dabei so ausgewählt, daß sie die Kapazitäten der aktiven Elemente kompensieren.

Der vorliegenden Erfindung liegt die Aufgabe zugrunde, einen Kettenverstärker der eingangs genannten Art für Ausgangsleistungen von 0,1 Watt bis 1 Watt anzugeben, dessen Bandweite extrem groß ist und dessen Frequenzbereich bis 18 GHz reicht.

Diese Aufgabe wird erfindungsgemäß durch einen Kettenverstärker nach dem Anspruch 1 gelöst.

Durch die Maßnahme, zur Schaltung nötige Induktivitäten und Kapazitäten zumindest teilweise durch die Eigenkapazitäten und -induktivitäten zu realisieren, können die parasitären Kapazitäten und Induktivitäten vorteilhaft ausgenutzt werden.

Es ist vorteilhaft, daß der Kettenverstärker bei einer Ausgangsleistung von 0,1 bis 1 Watt multioktav bis 18 GHz arbeitet, insbesondere daß der Kettenverstärker bei einer Frequenz bis zu 12 GHz arbeitet. Ein solcher Kettenverstärker bringt für Mikrowellenverstärker beachtliche Vorteile. Insbesondere ergeben sich eine hohe Verstärkung, eine hohe Linearität und eine hohe Leistung sowie niedrige Rauschzahlen. Ein solcher Mikrowellenverstärker dürfte einen optimalen Kompromiß aller gewünschten Hochfrequenz-Verstärkungseigenschaften aufweisen.

Es ist schaltungstechnisch vorteilhaft, daß als gemeinsames Source-Potential die Spannung U = 0 Volt gewählt wird.

Aus Gründen der leichten Anpassung an die äußeren Zuleitungen ist es vorteilhaft, daß der Verstärker eine Ein- und Ausgangsimpedanz von 50 Ω aufweist.

Es ist vorteilhaft, daß die Gate-Leitung wie die Drain-Leitung über im Halbleiterkörper integrierte ohmsche Widerstände hochfrequenzmäßig abgeschossen ist und daß die Gate-Leitung der nachfolgenden Verstärkerstufe mittels einer integrierten Koppelkapazität an die Drain-Leitung der vorhergehenden Stufe angeschlossen ist.

Es ist vorteilhaft, daß als Substrat Galliumarsenid (Ga As) verwendet wird und daß die verwendeten Feldeffekttransistoren Schottkykontakt-Feldeffekttransistoren sind.

Galliumarsenid als Substrat und Schottkykontakt-Feldeffekttransistoren haben sich für die dieser Erfindung zugrundeliegenden Zwecke als besonders geeignet erwiesen. Es sind jedoch durchaus auch andere Substratmaterialien wie z. B. Indiumphosphid oder ähnliche binäre, ternäre und quaternäre Verbindungshalbleiter geeignet.

Nachfolgend wird die Erfindung anhand der Zeichnung und an Ausführungsbeispielen näher erläutert.

Es zeigen:

Fig. 1 ein Ersatzschaltbild für einen zweistufigen erfindungsgemäßen Verstärker,

Fig. 2 eine Draufsicht auf einer Chipoberfläche, die eine Realisierung des Ersatzschaltbildes nach Fig. 1 darstellt.

Fig. 3 ein Ersatzschaltbild der Gate-Leitung,

Fig. 4 ein Ersatzschaltbild der Drain-Leitung.

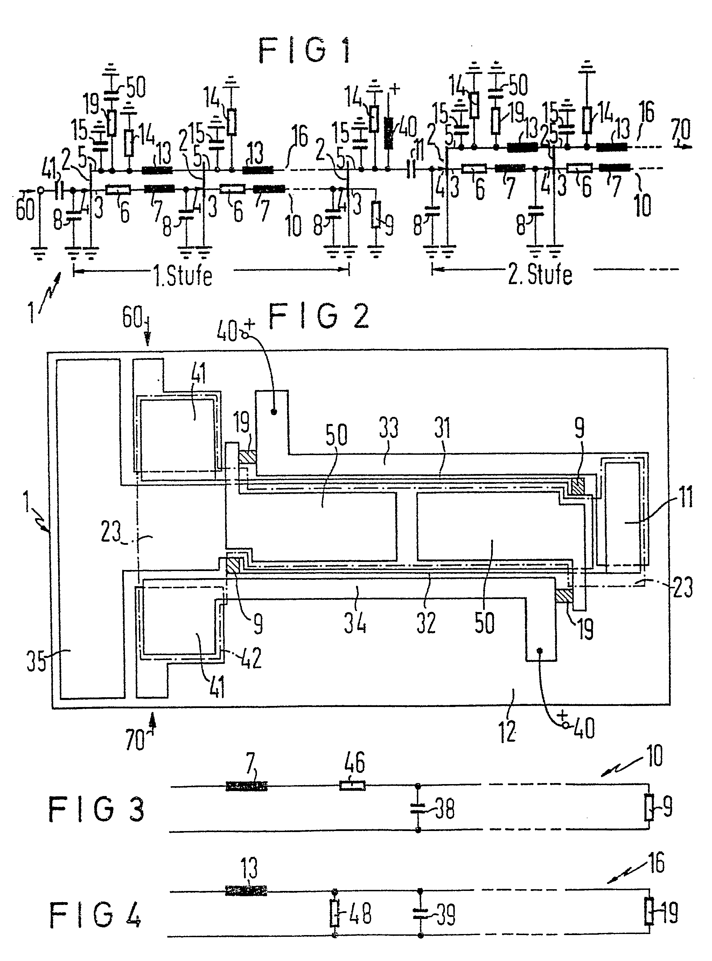

Fig. 1 zeigt einen Kettenverstärker 1, bestehend aus einer ersten Stufe und einer zweiten Stufe. Jede Stufe setzt sich aus einer Vielzahl von parallel geschalteten Feldeffekttransistoren 2 zusammen, welche einer kontinuierlichen Aufteilung eines einzigen Feldeffekttransistors bestehend aus dem Source 35, dem Drain 33 und dem Gate 31 aus Fig. 2 (erste Stufe) bzw. bestehend aus dem Source 35, dem Drain 34 und dem Gate 32 aus Fig. 2 (zweite Stufe) entsprechen. Jeder Feldeffekttransistor 2 verfügt über einen Source-Anschluß 3. Jeder dieser Source-Anschlüsse 3 liegt auf einem gemeinsamen Potential, welches nach dem Ausführungsbeispiel nach Fig. 1 als Erdpotential gewählt wurde. Als gemeinsames Potential kann jedoch auch ein anderes als das Erdpotential gewählt werden. Die Gate-Anschlüsse 4 sind abgesehen von den Eingängen und Ausgängen jeder Stufe miteinander durch hintereinander geschaltete ohmsche Widerstände 6 und Induktivitäten 7 und jeweils dazu parallel geschaltete Kapazitäten 8, verbunden von denen jeweils ein Anschluß auf dem gemeinsamen Source-Potential liegt. Die so verbundenen Gate-Anschlüsse 4 bilden zusammen mit dem Abschlußwiderstand 9 eine Gate-Leitung 10. Die Gate-Leitung 10 wird dabei so dimensioniert, daß sie als Wellenleiter ausgebildet ist, wie Fig. 3 zeigt, und kann wie in Fig. 2 dargestellt, durch die Gate-Kontakte 31 und 32 aus Fig. 2 sowie die Abschlußwiderstände 9 und dem gemeinsamen Source 35 realisiert werden. Die Drain-Anschlüsse 5 jedes Feldeffekttransistors 2 sind mittels der in Serie geschalteten Induktivitäten 13 miteinander verbunden. Parallel zu den Induktivitäten 13 sind jeweils ein ohmscher Widerstand 14 und eine Kapazität 15 so geschaltet, daß der zweite Anschluß der Kapazität 15 und des ohmschen Widerstandes 14 jeweils an das gemeinsame Source-Potential angelegt ist. Die Induktivitäten 13, die ohmschen Widerstände 14 und Kapazitäten 15 werden durch die verteilten Induktivitäten, ohmschen Widerstände und Kapazitäten der Drain-Kontakte 33, 34 aus Fig. 2 realisiert. Die Induktivitäten 13, die ohmschen Widerstände 14 und die Kapazitäten 15 bzw. die Drain-Kontakte 33 und 34 aus Fig. 2 bilden zusammen mit den Abschlußwiderständen 19 die Drain-Leitung 16 (vergl. auch Fig. 4). Die Drain-Leitung 16 ist ebenfalls wie die Gate-Leitung 10 so ausgelegt, daß sie als Wellenleiter fungiert. Mittels externer Induktivitäten 40, die bei geeigneter Materialwahl z.B. als Bonddraht nach Fig. 2 ausgebildet sein können, wird die Drain-Spannung an die Drain-Leitung 16 angelegt. Wird das Source-Potential wie in Fig. 1 dargestellt, als Erdpotential gewählt, so ist eine positive Drain-Spannung am offenen Ende der Induktivität 40 anzulegen, was durch ein kleines Pluszeichen an diesem Ende angedeutet wird. Die Kapazitäten 50 verhindern lediglich, daß die Drain-Leitungen 16 über die Abschlußwiderstände 19 direkt an das Erdpotential angelegt sind. Eingang 60 und Ausgang 70, angedeutet durch Pfeile, weisen Eingangs- und Ausgangsimpedanzen von je 50 $\Omega$ auf.

Fig. 2 stellt eine praktische Realisierung des Ersatzschaltbildes nach Fig. 1 dar. Ein Kettenverstärker 1 ist eingebracht in ein Substrat 12, das aus Halbleitermaterial insbesondere aus Galliumarsenid besteht. Die Substratdicke ist größer oder gleich 50 µm und beträgt vorzugsweise 100 µm bis 150 µm. Auf der Substratoberfläche sind die Drain-Kontakte 33, 34 vorzugsweise mit den Oberflächen-Abmessungen 300 µm × 50 µm ausgebildet, und die Gate-Kontakte 31, 32 vorzugsweise mit den Oberflächen-Abmessungen 300 µm × 1 µm ausgebildet. Außerdem ist der Source-Kontakt 35 großflächig auf der Halbleiteroberfläche abgeschieden. Zur Herstellung der Gate-Kontakte 31, 32 wird vorzugsweise Aluminium (Al) oder Schichtenfolgen wie Titan, Platin, Gold (TiPtAu) oder Chrom, Gold, Wolfram, Gold (CrAuWAu) verwendet. Zur Herstellung der Drain-Kontakte 33, 34 und des Source-Kontakts 35 werden vorzugsweise Schichtenfolgen aus Germanium, Gold, Chrom, Gold (GeAuCrAu), Germanium, Gold, Nickel (GeAuNi) oder Chrom, Gold, Wolfram, Gold (CrAuWAu) aufgebracht und einlegiert. Unter den metallisierten Bereichen ist das Halbleitersubstrat 12 in für Feldeffekttransistoren geeignete Weise dotiert. Der Gate-Kontakt 31, der Drain-Kontakt 33 und der Source-Kontakt 35 sind Hauptbestandteile der in der Fig. 1 mittels Pfeilen angedeuteten ersten Verstärkerstufe. In analoger Weise sind der Gate-Kontakt 32, der Drain-Kontakt 34 und der Source-Kontakt 35 Hauptbestandteile der zweiten Verstärkerstufe angedeutet durch Pfeile in Fig. 1. Die Erfindung beschränkt sich keineswegs auf zweistufige Verstärker, es können analog auch weitere Stufen angebaut sein. Weiterhin sind in der Fig. 2 die Abschlußwiderstände 9 für die Gate-Leitung (vgl. und Fig. 3 und Fig. 1) als schraffierte Bereiche dargestellt, was eine geeignete Dotierung dieser Bereiche unterhalb der Halbleiteroberfläche andeuten soll. Die Abschlußwiderstände 9 sind so dimensioniert, daß sie insbesondere 20 $\Omega$ aufweisen. In Fig. 1 ist der Abschlußwiderstand für das Gate der zweiten Stufe nicht dargestellt, ist aber analog zum Schaltbild der ersten Stufe bei der zweiten Stufe der Fig. 1 einzufügen.

Weitere Abschlußwiderstände 19 fungieren als Drainabschlußwiderstände und weisen einen Wert von insbesondere 55 $\Omega$ auf. Die Substratdotierung ist ebenfalls durch Schraffur angedeutet. Bei der Verwendung von Gallium-Arsenid als Substrat können Silicium (Si), Schwefel (S), Selen (Se) und Telur (Te) als Dotierstoffe verwendet werden. Außerdem ist die Koppelkapazität 11 zur Kopplung der ersten und zweiten Stufe angebracht. Integrierte Kapazitäten 41 am Ein- und Ausgang des Kettenverstärkers dienen der gleichspannungsmäßigen Entkopplung. Als Kondensator-Dielektrikum für die Kapazitäten 11, 41, 50 wird vorzugsweise Silicium-Nitrid ($Si_3N_4$) verwendet. Die Konturen der abgeschiedenen Isolatorschicht, z.B. Silicium-Nitrid sind in Fig. 2 durch die strichpunktierte Linie 42 dargestellt. Die Isolatorschicht dient außerdem auch an einigen Stellen zur Isolation sich kreuzender Leiterflächen bzw. von Leiter- und Halbleiterflächen. Die Koppelkapazitäten 11 und 41 betragen vorzugsweise 10 pF. Die Kapazitäten 50 betragen vorzugsweise 30 pF. Sie dient dazu, die ohmsche Verbindung zwischen den Drainkontakten 33, 34 über den Abschlußwiderstand 19 mit dem gemeinsamen Source-Potential zu verhindern. Die Induktivitäten 40 betragen vorzugsweise je 10 nH. Der Eingang 60 und der Ausgang 70 der Anordnung sind durch Pfeile angedeutet.

Fig. 3 und 4 enthalten Ersatzschaltbilder für die Gate-Leitung 10 und die Drainleitung 16. Gate- und Drain-Leitung wirken wie eine micro-stripe-waveguide-Leitung, wobei die Induktivitäten einerseits durch die verteilten Induktivitäten pro Gate-Länge der Gate-Kontakte 31, 32 gebildet werden und insbesondere 10 nH/cm betragen und andererseits durch die verteilten Induktivitäten pro Drain-Länge der Drain-Kontakte 33, 34 gebildet werden und insbesondere 2,7 nH/cm betragen. Die verteilten Kapazitäten pro cm Leitungslänge werden im Falle der Gate-Leitung 10 durch die Gate-Source-Kapazität 38 dargestellt, die sich im wesentlichen als Summe der in Fig. 1 dargestellten verteilten Kapazitäten 8 ergibt und 15 pF/cm beträgt. Bei der Drain-Leitung 16 werden die verteilten Kapazitäten durch die Drain-Kapazität 39 gebildet, die sich im wesentlichen aus der Summe der verteilten Kapazitäten 15 der Fig. 1 ergibt und die 1,7 pF/cm beträgt. Außerdem enthält die Gate-Leitung 10 einen verteilten Widerstand 46 von ca. 1000 Ohm pro cm Leitungslänge, während die Drain-Leitung eine parallelgeschaltete verteilte Steilheit 48 von 0,06 Siemens pro cm Leitungslänge hat, die den Schaltelementen 14 aus Fig. 1 entspricht. Die Impedanz der Gate-Leitung beträgt $\sqrt{L/C} = 25$ Ohm, die Impedanz der Drain-Leitung beträgt $\sqrt{L/C} = 40$ Ohm.

Das gesamte Bauelement wird so dimensioniert, daß die Eingangsimpedanz 50 Ohm beträgt, die Substratdicke wird so gewählt, daß sie so dünn wie technologisch möglich ist. Die geometrische Länge der Leitungen von Gate-Leitung und Drain-Leitung entspricht ungefähr der Wellenlänge W, die ca. 300 µm beträgt.

Der Energietransport findet an der Oberfläche des Substrats statt. Die parasitären Kapazitäten gegen die Substratrückseite, z.B. insbesondere gegen Masse, sind vergleichsweise klein und deshalb vernachlässigbar.

Ein erfindungsgemäßer Kettenverstärker weist eine feinstmögliche Elementquantelung, d.h. eine echte Distribution der Einzelbauelemente auf. Theoretisch gibt es damit entsprechend der Leitungstheorie keine parasitären Effekte; die Grenzfrequenz kann deutlich erhöht werden. Neben einem gleichmäßigen Verstärkungsverlauf erlaubt das Prinzip eine optimale Eingangs- und Ausgangsanpassung, d.h. der Verstärker kann auf 50 Ω Eingangs- und Ausgangsimpedanz ausgelegt werden. Je nach Transistorgröße (Gatewidth) und Stufenzahl des Verstärkers ergibt sich eine entsprechend hohe Verstärkung, Linearität und Leistung sowie niedrige Rauschzahlen. Diese Verstärkerart dürfte den bestmöglichen Kompromiß aller gewünschten Hochfrequenzverstärkereigenschaften darstellen.

Der erfindungsgemäße Verstärker arbeitet für kleine und mittlere Ausgangsleistungen von ca. 0,1 W bis 1 W. Er weist einen Frequenzbereich von mindestens einer Oktave auf und arbeitet bis zu einer Grenzfrequenz von ca. 18 GHz.

Erfindungsgemäße Verstärker lassen sich für den Mikrowellenbereich, speziell für TV-Satelliten bei Frequenzen von 4 GHz, 6 GHz, 8 GHz und 10 GHz und 12 GHz besonders vorteilhaft anwenden.

**Patentansprüche**

1. Kettenverstärker (1), bestehend aus einer oder mehreren Verstärkerstufen, wobei jede Stufe mehrere Feldeffekttransistoren (2) enthält, die so geschaltet sind, daß alle Sourceanschlüsse (3) auf einem bestimmten gemeinsamen Potential liegen, alle Gateanschlüsse (4) mittels in Reihe geschalteter ohm'scher Widerstände (6) und Induktivitäten (7) miteinander zu einer Gate-Leitung (10) verbunden sind und Kapazitäten (8) an die Gate-Leitung (10) so angeschlossen sind, daß die mit der Gate-Leitung (10) nicht verbundenen Anschlüsse der Kapazitäten (8) jeweils auf dem gemeinsamen Source-Potential liegen, alle Drainanschlüsse (5) mittels in Reihe geschalteter Induktivitäten (13) zu einer Drain-Leitung (16) verbunden sind und die Drain-Leitung (16) einerseits mittels an die Drain-Leitung (16) angeschlossener ohm'scher Widerstände (14) mit dem gemeinsamen Source-Potential verbunden ist und andererseits mittels an die Drain-Leitung angeschlossener Kapazitäten (15) mit dem gemeinsamen Source-Potential verbunden ist und wobei am Eingang (60), Ausgang (70) und beim Übergang von einer Stufe zur nächstfolgenden Stufe Kapazitäten, Induktivitäten und ohm'sche Widerstände als Anpassungselemente vorgesehen sind, und wobei die Eingangs- und Ausgangs-Leitungen als Wellenleiter fungieren, dadurch gekennzeichnet, daß die Elemente sowohl der Drain-Leitung (16) wie der Gate-Leitung (10) so dimensioniert sind, daß diese Drain- und Gate-Leitungen als Wellenleiter fungieren und daß zumindest zur teilweisen Realisierung der Wellenleiter durch geeignete Materialauswahl und Materialdimensionierung alle Metallbeschichtungen, Isolatorbeschichtungen und Dotierungskonzentrationen auch der Drain- und Source-Bereiche der Feldeffekttransistoren ausgenutzt werden, und daß zusätzlich erforderliche Schaltelemente monolithisch in den Halbleiterkörper integriert sind.

2. Kettenverstärker nach Anspruch 1, dadurch gekennzeichnet, dass der Kettenverstärker (1) bei einer Ausgangsleistung von 0,1 bis 1 Watt multioktav bis 18 GHz arbeitet.

3. Kettenverstärker nach Anspruch 2, dadurch gekennzeichnet, daß der Kettenverstärker (1) bei einer Frequenz bis zu 12 GHz arbeitet.

4. Kettenverstärker nach mindestens einem der Ansprüche 1 bis 3, dadurch gekennzeichnet, daß als gemeinsames Source-Potential die Spannung U = 0 Volt gewählt wird.

5. Kettenverstärker nach mindestens einem der Ansprüche 1 bis 4, dadurch gekennzeichnet, daß der Kettenverstärker (1) eine Ein- und Ausgangsimpedanz von 50 Ohm aufweist.

6. Kettenverstärker nach mindestens einem der Ansprüche 1 bis 5, dadurch gekennzeichnet, daß die Gate-Leitung (10) wie die Drain-Leitung (16) über im Halbleiterkörper integrierte ohmsche Widerstände (19) bzw. (9) hochfrequenzmäßig abgeschlossen ist und daß die Gate-Leitung (10) der nachfolgenden Verstärkerstufe mittels einer integrierten Koppelkapazität (11) an die Drain-Leitung (16) der vorhergehenden Stufe angeschlossen ist.

7. Kettenverstärker nach mindestens einem der Ansprüche 1 bis 6, dadurch gekennzeichnet, daß als Substrat (12) Galliumarsenid (Ga As) verwendet wird.

8. Kettenverstärker nach mindestens einem der Ansprüche 1 bis 7, dadurch gekennzeichnet, daß die verwendeten Feldeffekttransistoren Schottkykontakt-Feldeffekttransistoren sind.

**Claims**

Distributed amplifier (1) consisting of one or several amplifier stages, each stage containing several field-effect transistors (2) which are connected in such a manner that all source connections (3) are at a particular common potential, all gate connections (4) are connected to one another by means of series-connected ohmic resistances (6) and inductances (7) to from one gate line (10) and capacitances (8) are connected to the gate line (10) in such a manner that the connections of the capacitances (8) which are not connected to the gate line (10) are in each case connected to the common source potential, all drain connections (5) are connected by means of series-connected inductances (13) to form one drain line (16) and the drain line (16) is connected, on the one hand, by means of ohmic resistances (14) connected to the drain line (16) to the common source potential and, on the other hand, is connected by means of capacitances (15) connected to the drain line to the common source potential and capacitances, inductances and ohmic resistances are provided as matching elements at the input (60), output (70) and at the transition from one stage to the next-following stage, and the input and output lines functioning as waveguides, characterized in that the elements both of the drain line (16) and of the gate line (10) are dimensioned in such a manner that these drain and gate lines function as waveguides and that, at least for the partial implementation of the waveguides by means of a suitable selection of material and dimensioning of material, all metal coatings, insulator coatings and doping concentrations also of the drain and source areas of the field-effect transistors are utilised and that additionally required circuit elements are monolithically integrated in the semiconductor body.

2. Distributed amplifier according to Claim 1, characterized in that the distributed amplifier (1) operates over several octaves up to 18 GHz at an output power of 0.1 to 1 Watt.

3. Distributed amplifier according to Claim 2, characterized in that the distributed amplifier (1) operates at a frequency of up to 12 GHz.

4. Distributed amplifier according to at least one of Claims 1 to 3, characterized in that the voltage U = 0 volt is selected as common source potential.

5. Distributed amplifier according to at least one of Claims 1 to 4, characterized in that the distributed amplifier (1) exhibits an input and output impedance of 50 ohms.

6. Distributed amplifier according to at least one of Claims 1 to 5, characterized in that the gate line (10) and the drain line (16) is terminated with respect to radio frequency via ohmic resistances (19) and (9) integrated in the semiconductor body and that the gate line (10) of the subsequent amplifier stage is connected to the drain line (16) of the preceding stage by means of an integrated coupling capacitance (11).

7. Distributed amplifier according to at least one of the Claims 1 to 6, characterized in that gallium arsenide (Ga As) is used as substrate (12).

8. Distributed amplifier according to at least one of Claims 1 to 7, characterized in that the field-effect transistors used are Schottky contact field-effect transistors.

## Revendications

1. Amplificateur distribué (1) comprenant un ou plusieurs étages d'amplification, dans lequel chaque étage contient plusieurs transistors à effet de champ (2) qui sont branchés de manière que toutes les connexions de source (3) se trouvent à un potentiel commun déterminé, que toutes les connexions de grille (4) soient reliées ensemble en une ligne de grille (10) au moyen de résistances ohmiques (6) et d'inductances (7) branchées en série et que des capacités (8) soient raccordées à la ligne de grille (10) de façon que les connexions non reliées à cette ligne (10) des capacités (8) se trouvent au potentiel de source commun, que toutes les connexions de drain (5) soient reliées en une ligne de drain (16) au moyen d'inductances (13) branchées en série et que la ligne de drain (16) soit reliée au potentiel de source commun d'une part, par des résistances ohmiques (14) raccordées à la ligne de drain (16) et d'autre part par des capacités (15) raccordées à cette ligne (16), des capacités, des inductances et des résistances ohmiques étant prévues en tant qu'éléments d'adaptation à l'entré (60), à la sortie (70) et au passage d'une étage à l'étage suivant, alors que les lignes d'entrée et de sortie font office de quides d'ondes, caractérisé en ce que les éléments de la ligne de drain (16) comme ceux de la ligne de grille (10) sont dimensionnés de manière que ces lignes de drain et de grille fassent office de guides d'ondes, que tous les revêtements métalliques, revêtements isolants et concentrations de dopage, y compris des zones de drain et de source des transistors à effet de champ, sont exploités, par le choix approprié des matériaux et de leurs dimensions, pour la réalisation au moins partielle des guides d'ondes et que des éléments de circuit nécessaires en plus sont intégrés monolithiquement dans le corps semi-conducteur.

2. Amplificateur selon la revendication 1, caractérisé en ce qu'il fonctionne sur plusieurs octaves, jusqu'à 18 GHz, avec une puissance de sortie de 0,1 à 1 watt.

3. Amplificateur selon la revendication 2, caractérisé en ce qu'il fonctionne à une fréquence allant jusqu'à 12 GHz.

4. Amplificateur selon au moins une des revendications 1 à 3, caractérisé en ce que la tension U = 0 volt est choisie en tant que potentiel de source commun.

5. Amplificateur selon au moins une des revendications 1 à 4, caractérisé en ce qu'il présente une impédance d'entrée et une impédance de sortie de 50 ohms.

6. Amplificateur selon au moins une des revendications 1 à 5, caractérisé en ce que la ligne de grille (10), comme la ligne de drain (16), est terminée pour la haute fréquence par des résistances ohmiques (19 ou 9) intégrées dans le corps semiconducteur et que la ligne de grille (10) de l'étage d'amplification suivant est raccordée à la ligne de drain (16) de l'étage précédent par une capacité de couplage (11) intégrée.

7. Amplificateur selon au moins une des revendications 1 à 6, caractérisé en ce que le substrat (12) est en arséniure de gallium (Ga As).

8. Amplificateur selon au moins une des revendications 1 à 7, caractérisé en ce que les transistors à effet de champ utilisés sont du type à contact de Schottky.

6

# F I G 1

1.Stufe — 2.Stufe

# F I G 2

# F I G 3

# F I G 4